# EUROPEAN PATENT APPLICATION

(11) **EP 3 264 445 A1**
(43) Date of publication of application: **03.01.2018**
(21) Application number: 16755193.6
(22) Date of filing: 08.02.2016
(51) Int. Cl.: H01L 21/205, C30B 25/18, C30B 29/38, H01L 21/20, H01L 33/12, H01L 33/32

(54) **NITRIDE SEMICONDUCTOR TEMPLATE AND METHOD FOR MANUFACTURING SAME**

(30) Priority: 25.02.2015 JP 2015035895
(71) Applicant: Tamura Corporation, Tokyo 178-8511 (JP); Riken, Wako-shi, Saitama 351-0198 (JP)
(72) Inventor: MORISHIMA, Yoshikatsu, Tokyo 178-8511 (JP); IIZUKA, Kazuyuki, Tokyo 178-8511 (JP); KURAMATA, Akito, Tokyo 178-8511 (JP); HIRAYAMA, Hideki, Wako-shi Saitama 351-0198 (JP)
(74) Representative: Betten & Resch
(86) International application number: PCT/JP2016/053695
(87) International publication number: WO 2016/136446

(57) **Abstract**

[Problem]

To provide a transparent nitride semiconductor template having a high-quality nitride semiconductor, being suitable for use in an ultraviolet LED, and having electroconductivity, and a manufacturing method allowing simple manufacture of same.

[Solution]

Provided is a nitride semiconductor template 10 having: a Ga₂O₃ substrate 11; a buffer layer 12 formed on the Ga₂O₃ substrate 11 and having AlN as a principal component; a first nitride semiconductor layer 13 formed on the buffer layer 12 and having AlₓGa₁₋ₓN (0.2 < x ≤ 1) as a principal component; and a second nitride semiconductor layer 14 formed on the first nitride semiconductor layer 13 and having Al_{y}Ga_{1-y}N (0.2 ≤ y ≤ 0.55, y < x) as a principal component.

## Description

### [Technical Field]

The invention relates to a nitride semiconductor template and a method for manufacturing the nitride semiconductor template.

### [Background Art]

A nitride semiconductor template is known in which a nitride semiconductor layer is formed on a Ga₂O₃ substrate via an AlN buffer layer (see, e.g., PTL 1)

According to PTL 1, appropriately selecting a plane orientation of a main surface of the Ga₂O₃ substrate allows the nitride semiconductor layer to have a mirror surface.

### [Citation List]

### [Patent Literature]

[PTL **1**] JP-A 2014-199935

### [Summary of Invention]

### [Technical Problem]

When forming a nitride semiconductor on the Ga₂O₃ substrate, however, the conditions to prevent pits or cracks on the nitride semiconductor are different depending on the amount of the Al composition of the nitride semiconductor. Therefore, the optimal method needs to be chosen for each composition to obtain a higher-quality nitride semiconductor.

In recent years, ultraviolet LEDs in the wavelength range of **315** to **360** nm have been developed as an alternative to high-pressure mercury lamps used for curing, etc.

It is an object of the invention to provide a transparent nitride semiconductor template that includes a high-quality nitride semiconductor, is suitable for use in an ultraviolet LED and has an electrical conductivity, as well as a manufacturing method that allows simple manufacture of the transparent nitride semiconductor template.

### [Solution to Problem]

To achieve the above-mentioned object, an aspect of the invention provides a nitride semiconductor template described in the following [**1**] to [**5**] and a method for manufacturing a nitride semiconductor template described in the following [**6**] to [**8**].
[**1**] A nitride semiconductor template, comprising: a Ga₂O₃ substrate; a buffer layer formed on the Ga₂O₃ substrate and comprising AlN as a principal component; a first nitride semiconductor layer formed on the buffer layer and comprising AlₓGa₁₋ₓN (**0.2**<x≤**1**) as a principal component; and a second nitride semiconductor layer formed on the first nitride semiconductor layer and comprising Al_{y}Ga_{1-y}N (**0.2**≤y≤**0.55**, y<x) as a principal component.
[**2**] The nitride semiconductor template described in [**1**], wherein the buffer layer is not more than **10** nm in thickness.
[**3**] The nitride semiconductor template described in [**1**] or [**2**], wherein the second nitride semiconductor layer has no crack on a surface thereof.
[**4**] The nitride semiconductor template described in [**1**] or [**2**], wherein the second nitride semiconductor layer has no pit on a surface thereof.
[**5**] The nitride semiconductor template described in [**1**] or [**2**], wherein the second nitride semiconductor layer has a dislocation density of not more than **2.0x10¹⁰** cm⁻².
[**6**] A method for manufacturing a nitride semiconductor template, comprising: a step of forming a Ga₂O₃ substrate; a step of forming a buffer layer comprising AlN as a principal component on the Ga₂O₃ substrate; a step of forming a first nitride semiconductor layer comprising AlₓGa₁₋ₓN (**0.2**<x≤**1**) as a principal component on the buffer layer; and a step of forming a second nitride semiconductor layer comprising Al_{y}Ga_{1-y}N (**0.2**≤y≤**0.55**, y<x) as a principal component on the first nitride semiconductor layer.
[**7**] The method for manufacturing a nitride semiconductor template described in [**6**], wherein the buffer layer is not more than **10** nm in thickness.
[**8**] The method for manufacturing a nitride semiconductor template described in [**6**] or [**7**], wherein a growth temperature of the second nitride semiconductor layer is more than **1100°C,** and a growth temperature of the first nitride semiconductor layer is less than **1100°C.**

### [Advantageous Effects of Invention]

According to the invention, a transparent nitride semiconductor template can be provided that includes a high-quality nitride semiconductor, is suitable for use in an ultraviolet LED and has electrical conductivity, as well as a manufacturing method that allows simple manufacture of the transparent nitride semiconductor template.

### [Brief Description of Drawings]

**FIG.1** is a vertical cross-sectional view showing a nitride semiconductor template in an embodiment.
**FIG.2A** is an image of a surface of a second nitride semiconductor layer of Sample **1** observed under an optical microscope.
**FIG.2B** is an image of a surface of a second nitride semiconductor layer of Sample **4** observed under an optical microscope.
**FIG.2C** is an image of a surface of a second nitride semiconductor layer of Sample **5** observed under an optical microscope.
**FIG.3** is an X-ray diffraction pattern of the nitride semiconductor template as Sample **5** obtained using a symmetrical reflection method.
**FIG.4** shows photoluminescence spectra of the nitride semiconductor template as Sample **5.**

### [Description of Embodiment]

### [Embodiment]

### (Structure of Nitride semiconductor template)

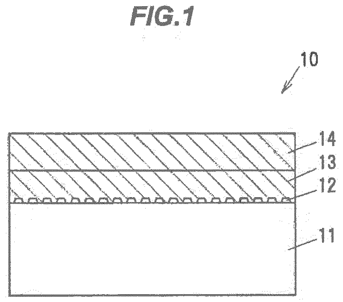

**FIG.1** is a vertical cross-sectional view showing a nitride semiconductor template **10** in the embodiment. The nitride semiconductor template **10** is a template suitable for use in an ultraviolet LED with an emission wavelength of **315** to **360** nm.

The nitride semiconductor template **10** includes a Ga₂O₃ substrate **11,** a buffer layer **12** on the Ga₂O₃ substrate **11,** a first nitride semiconductor layer **13** on the buffer layer **12,** and a second nitride semiconductor layer **14** on the first nitride semiconductor layer **13.**

The Ga₂O₃ substrate **11** is formed of a β-Ga₂O₃ single crystal. The main surface of the Ga₂O₃ substrate **11** is a **(-201)** plane, a **(101)** plane, a **(310)** plane, a **(3-10)** plane or planes inclined from these planes within a range of about ±2°, which can be a base for growth of high-quality nitride semiconductor crystal. The Ga₂O₃ substrate **11** is, e.g., a circular substrate having a diameter of **50.8** mm (**2** inches), but the shape and size thereof are not limited.

Since Ga₂O₃ hardly absorbs light with a wavelength of **315** to **360** nm, the Ga₂O₃ substrate **11** is excellent as a substrate of the nitride semiconductor template **10** which is used to form an UV LED with an emission wavelength of **315** to **360** nm. By contrast, e.g., GaN absorbs light with a wavelength of **315** to **360** nm well. Therefore, GaN substrates are not suitable as UV LED templates, and to prevent a decrease in light extraction efficiency, the GaN substrates need to be removed after manufacturing LEDs.

In addition, the Ga₂O₃ substrate **11,** which contains a dopant such as Si or Sn and has excellent conductivity, is excellent as an LED substrate. On the other hand, in case that a low-conductivity substrate, e.g., a sapphire substrate, is used, it is not possible to form vertical-type LEDs, and horizontal-type LEDs, even when formed, have high electrical resistance since an electric current flows through a thin nitride semiconductor layer on the substrate.

The buffer layer **12** is formed of a crystal consisting mainly of AlN. The buffer layer **12** may partially cover the upper surface of the Ga₂O₃ substrate **11** as shown in **FIG.1****,** or may cover the entire upper surface. To obtain higher crystal quality, the thickness of the buffer layer **12** is preferably not more than **10** nm, more preferably, not more than **5** nm.

The second nitride semiconductor layer **14** is used as a cladding layer in a UV LED which is formed using the nitride semiconductor template **10.** To form a UV LED with an emission wavelength of **315** to **360** nm, the second nitride semiconductor layer **14** to be a cladding layer need to have a composition roughly represented by Al_{y}Ga_{1-y}N (**0.2**≤y≤**0.55**).

The Al composition of the first nitride semiconductor layer **13** is greater than that of the second nitride semiconductor layer **14.** In other words, the composition of the first nitride semiconductor layer **13** is expressed by AlₓGa₁₋ₓN (**0.2**<x≤**1**), and the Al composition-x of the first nitride semiconductor layer **13** and the Al composition-y of the second nitride semiconductor layer **14** satisfy the relation of y<x. The first nitride semiconductor layer **13** having such a composition allows the second nitride semiconductor layer **14** to have a mirror surface and generation of cracks and pits to be suppressed.

The first nitride semiconductor layer **13** and the second nitride semiconductor layer **14** may contain a dopant such as Si. The thickness of the first nitride semiconductor layer **13** is, e.g., **100** to **300** nm. The thickness of the second nitride semiconductor layer **14** is, e.g., **1** to **2** µm.

The surface of the second nitride semiconductor layer **14** is a mirror surface and hardly contains, or does not contain cracks and pits (hole-like defects) at all.

If the second nitride semiconductor layer **14** is formed on the buffer layer **12** without providing the first nitride semiconductor layer **13,** cracks are generated on the surface of the second nitride semiconductor layer **14.** Meanwhile, when only the first nitride semiconductor layer **13** is formed on the buffer layer **12** without providing the second nitride semiconductor layer **14,** a mirror surface cannot be obtained.

### (Method for manufacturing Nitride semiconductor template)

An example method for manufacturing the nitride semiconductor template **10** will be described below.

Firstly, the Ga₂O₃ substrate **11** treated by CMP (Chemical Mechanical Polishing) is cleaned with an organic solvent and SPM (Sulfuric acid/hydrogen peroxide mixture).

Next, the Ga₂O₃ substrate **11** is conveyed to a chamber of a MOCVD (Metal Organic Chemical Vapor Deposition) apparatus.

Next, the buffer layer **12** is formed on the Ga₂O₃ substrate **11.** An AlN crystal is grown on the Ga₂O₃ substrate **11** by supplying source gases and N₂ gas as a carrier gas into the chamber in a state that the temperature inside the chamber is maintained at **400** to **600**°C, thereby forming the buffer layer **12** in the form of film.

The source gases used to form the buffer layer **12** are, e.g., trimethylaluminum (TMA) gas as an Al source and NH₃ gas as an N source. The carrier gas may be alternatively H₂ gas, etc.

Next, the first nitride semiconductor layer **13** is formed on the buffer layer **12.** In detail, for example, source gases for the first nitride semiconductor layer **13** and H₂ gas as a carrier gas are supplied into the chamber with pressure maintained at **100** mbar and temperature maintained at not less than **885**°C, thereby growing the first nitride semiconductor layer **13.**

The source gases used to form the nitride semiconductor layer **13** are, e.g., trimethylaluminum (TMA) gas as an Al source, trimethylgallium (TMG) gas as Ga source and NH₃ gas as an N source. The carrier gas may be alternatively N₂ gas, etc.

Next, the second nitride semiconductor layer **14** is formed on the first nitride semiconductor layer **13.** In detail, for example, source gases for the second nitride semiconductor layer **14** and H₂ gas as a carrier gas are supplied into the chamber with temperature maintained at not less than **1100**°C, thereby growing the second nitride semiconductor layer **14.**

Here, generation of pits can be suppressed when the second nitride semiconductor layer **14** is grown at a growth temperature of more than **1100**°C. Furthermore, generation of pits can be suppressed more reliably when the second nitride semiconductor layer **14** is grown at a growth temperature of not less than **1120**°C.

The source gases for the second nitride semiconductor layer **14** may be the same as those for the first nitride semiconductor layer **13.** The carrier gas may be alternatively N₂ gas, etc.

### (Evaluation of Surface state of Second nitride semiconductor layer)

Table **1** below shows the growth conditions of each layer and the results of evaluating the surface state of the second nitride semiconductor layers.

Each of the Ga₂O₃ substrates of seven types of nitride semiconductor templates (Samples **1** to **7**) used for evaluation was a **2** inch-diameter circular substrate having a (-**201**) plane as the main surface. Trimethylaluminum (TMA) gas, trimethylgallium (TMG) gas and NH₃ gas were respectively used as the Al source, the Ga source and the N source for the first and second nitride semiconductor layers.

**Table 1**

| Sample No. | Buffer layer | | First nitride semiconductor layer | | Second nitride semiconductor layer | | Surface state | | |
|---|---|---|---|---|---|---|---|---|---|
| | Film thickness [nm] | Growth temperature [°C] | Composition | Growth temperature [°C] | Composition | Growth temperature [°C] | Check of etched Ga₂O₃ substrate | Pit | Crack |
| 1 | 5 | 550 | N/A | N/A | Al_{0.3}Ga_{0.7}N | 1100 | Etched | Observed | Observed |
| 2 | 5 | 800 | N/A | N/A | Al_{0.3}Ga_{0.7}N | 1100 | Etched | Observed | Observed |
| 3 | 5 | 550 | Al_{0.3}Ga_{0.7}N | 1020 | Al_{0.3}Ga_{0.7}N | 1100 | Not etched | Observed | Observed |
| 4 | 5 | 550 | AlN | 1020 | Al_{0.3}Ga_{0.7}N | 1100 | Not etched | Observed | Not observed |
| 5 | 5 | 550 | AlN | 1020 | Al_{0.3}Ga_{0.7}N | 1120 | Not etched | Not observed | Not observed |
| 6 | 5 | 550 | Al_{0.8}Ga_{0.2}N | 1020 | Al_{0.3}Ga_{0.7}N | 1120 | Not etched | Not observed | Not observed |
| 7 | 5 | 550 | Al_{0.8}Ga_{0.2}N | 1020 | Al_{0.45}Ga_{0.55}N | 1120 | Not etched | Not observed | Not observed |

The second nitride semiconductor layer of each of Samples **1** to **7** was grown at a growth rate of **2** µm/h.

In Samples **1** and **2,** the second nitride semiconductor layer was directly formed on the buffer layer without forming the first nitride semiconductor layer. Pits and cracks were generated on the surface of the second nitride semiconductor layer of Sample **1** and a mirror surface was obtained only in a **25** mm-diameter region. Likewise, pits and cracks were generated also on the surface of the second nitride semiconductor layer of Sample **2.** It is considered that this is because the first nitride semiconductor layer was not formed.

Meanwhile, in Sample **1,** the Ga₂O₃ substrate was partially etched. The reason is considered as follows: since the second nitride semiconductor layer to be grown at a higher temperature than the first nitride semiconductor layer was directly formed on the buffer layer, the buffer layer migrated (or crystallized) too much and thus did not sufficiently protect some portion of the surface of the Ga₂O₃ substrate. On the other hand, in Sample **2,** the Ga₂O₃ substrate was etched when forming the buffer layer since the growth temperature of the buffer layer was too high.

In Sample **3,** cracks were generated on the surface of the second nitride semiconductor layer. It is considered that this is because the Al composition of the first nitride semiconductor layer was the same as that of the second nitride semiconductor layer.

In Sample **4,** pits were generated on the surface of the second nitride semiconductor layer. It is considered that this is because growth of the crystal in the lateral direction was insufficient when the second nitride semiconductor layer was grown at a temperature of **1100**°C.

In Sample **5,** none of cracks and pits were generated on the surface of the second nitride semiconductor layer. It is considered that this is mainly because the first and second nitride semiconductor layers were both formed and the Al composition of the second nitride semiconductor layer was smaller than that of the first nitride semiconductor layer. The reason why pits were not generated is considered that the second nitride semiconductor layer was grown at a temperature of **1120**°C, i.e., higher than **1100**°C.

Sample **6** was the same as Sample **5,** except that the material of the first nitride semiconductor layer was changed to Al_{0.8}Ga_{0.2}N from AlN to decrease electrical resistance of the first nitride semiconductor layer. Also in Sample **6,** none of cracks and pits were generated.

In Sample **7,** the Al composition of the second nitride semiconductor layer was increased to more than that of Samples **5** and **6** for use in LEDs with a short wavelength. Also in Sample **7,** none of cracks and pits were generated.

In all of Samples **1** to **7,** dislocation density in the second nitride semiconductor layer was suppressed to not more than **2.0x10¹⁰**cm⁻².

It is understood from the evaluation results of Samples **1** to **7** that the conditions to obtain the second nitride semiconductor layer with a good surface state are that the first and second nitride semiconductor layers are both formed, that the Al composition of the second nitride semiconductor layer is smaller than that of the first nitride semiconductor layer, and that the growth temperature of the second nitride semiconductor layer is more than **1100**°C.

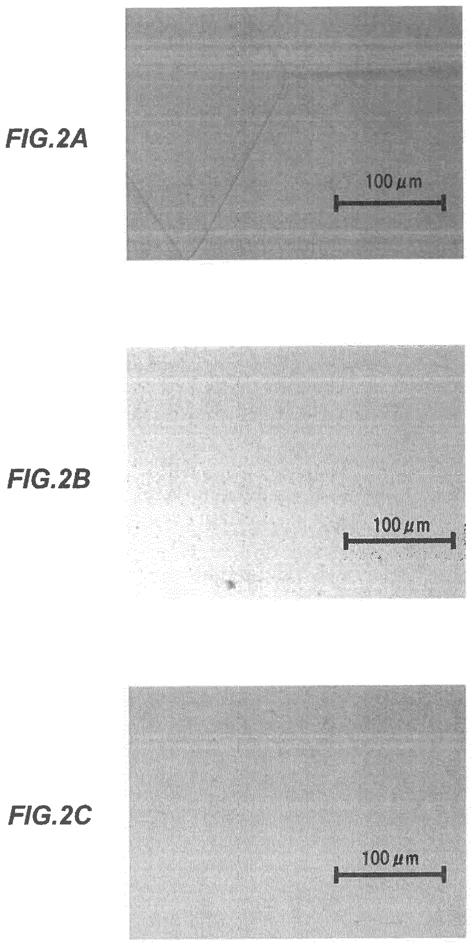

**FIGS.2A, 2B** and **2C** are images of the surfaces of the respective second nitride semiconductor layers of Samples **1, 4** and **5** observed under an optical microscope. As shown in Table **1,** cracks are observed on the surface of the second nitride semiconductor layer of Sample **1** shown in **FIG.2A****,** and pits are observed on the surface of the second nitride semiconductor layer of Sample **4** shown in **FIG.2B****.** On the other hand, none of cracks and pits are observed on the surface of the second nitride semiconductor layer of Sample **5** shown in **FIG.2C****.**

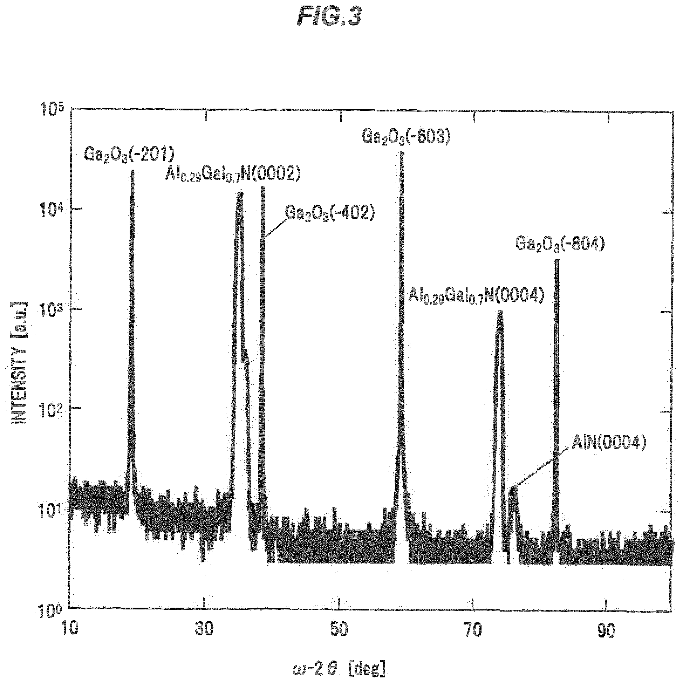

**FIG.3** is an X-ray diffraction pattern of the nitride semiconductor template as Sample **5.**

The X-ray diffraction pattern in **FIG.3** only has peaks of diffraction from the Ga₂O₃ substrate at a (-**201**) plane and planes parallel to the (-**201**) plane, from AlN as the first nitride semiconductor layer at a plane parallel to a (**0001**) plane and from Al_{0.3}Ga_{0.7}N as the second nitride semiconductor layer at planes parallel to a (**0001**) plane, and shows that the second nitride semiconductor layer does not have a phase grown in a different direction. Note that, the Al composition is shown as Al_{0.29}Ga_{0.71}N in **FIG.3** since the Al composition of Al_{0.3}Ga_{0.7}N was actually **0.29** as a result of calculation based on complete lattice relaxation derived from the peak position.

Meanwhile, as a result of x-ray rocking curve measurement on the nitride semiconductor template as Sample **5,** the full width at half maximum of diffraction peak from a (**0002**) plane was **1164** arcseconds and the full width at half maximum of diffraction peak from a (**1-102**) plane was **1536** arcseconds.

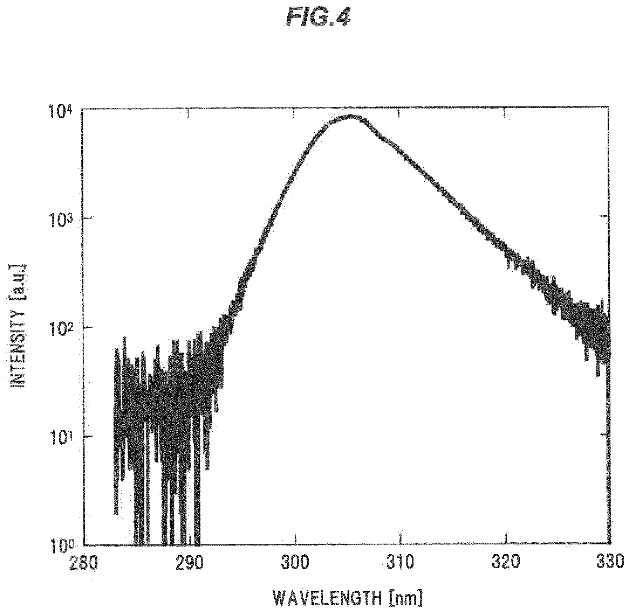

**FIG.4** shows photoluminescence spectra of the nitride semiconductor template as Sample **5.** This spectrum was obtained by photoluminescence measurement using excitation light with a wavelength of **244** nm at room temperature, and the peak at a wavelength of **305** nm probably due to band edge emission is shown as a main peak.

### (Effects of the embodiment)

In the embodiment, it is possible to obtain a nitride semiconductor template which has a high-quality nitride semiconductor on a Ga₂O₃ substrate and is suitable for use in a UV LED with an emission wavelength of **315** to **360** nm.

Although the embodiment of the invention has been described, the invention is not intended to be limited to the embodiment, and the various kinds of modifications can be implemented without departing from the gist of the invention.

In addition, the invention according to claims is not to be limited to embodiment. Further, it should be noted that all combinations of the features described in the embodiment are not necessary to solve the problem of the invention.

### [Industrial Applicability]

Provided is a transparent nitride semiconductor template that includes a high-quality nitride semiconductor, is suitable for use in an ultraviolet LED and has electrical conductivity, as well as a manufacturing method that allows simple manufacture of the transparent nitride semiconductor template.

### [Reference Signs List]

**10** NITRIDE SEMICONDUCTOR TEMPLATE
**11** Ga₂O₃ SUBSTRATE
**12** BUFFER LAYER
**13** FIRST NITRIDE SEMICONDUCTOR LAYER
**14** SECOND NITRIDE SEMICONDUCTOR LAYER

## Claims

1. A nitride semiconductor template, comprising:
a Ga₂O₃ substrate;
a buffer layer formed on the Ga₂O₃ substrate and comprising AlN as a principal component;
a first nitride semiconductor layer formed on the buffer layer and comprising AlₓGa₁₋ₓN (**0.2<x≤1**) as a principal component; and
a second nitride semiconductor layer formed on the first nitride semiconductor layer and comprising Al_{y}Ga_{1-y}N (**0.2**≤y≤**0.55**, y<x) as a principal component.

2. The nitride semiconductor template according to claim **1,** wherein the buffer layer is not more than **10** nm in thickness.

3. The nitride semiconductor template according to claim **1** or **2**, wherein the second nitride semiconductor layer has no crack on a surface thereof.

4. The nitride semiconductor template according to claim **1** or **2**, wherein the second nitride semiconductor layer has no pit on a surface thereof.

5. The nitride semiconductor template according to claim **1** or **2,** wherein the second nitride semiconductor layer has a dislocation density of not more than **2.0x10¹⁰** cm⁻².

6. A method for manufacturing a nitride semiconductor template, comprising:
a step of forming a Ga₂O₃ substrate;
a step of forming a buffer layer comprising AlN as a principal component on the Ga₂O₃ substrate;
a step of forming a first nitride semiconductor layer comprising AlₓGa₁₋ₓN (**0.2**<x≤**1**) as a principal component on the buffer layer; and
a step of forming a second nitride semiconductor layer comprising Al_{y}Ga_{1-y}N (**0.2**≤y≤**0.55**, y<x) as a principal component on the first nitride semiconductor layer.

7. The method for manufacturing a nitride semiconductor template according to claim **6,** wherein the buffer layer is not more than **10** nm in thickness.

8. The method for manufacturing a nitride semiconductor template according to claim **6** or **7,** wherein a growth temperature of the second nitride semiconductor layer is more than **1100**°C, and a growth temperature of the first nitride semiconductor layer is less than **1100**°C.
